# EUROPEAN PATENT SPECIFICATION

(11) **EP 1 177 557 B1**
(45) Date of publication and mention of the grant of the patent: **30.06.2004**
(21) Application number: 00930236.5
(22) Date of filing: 28.04.2000
(51) Int. Cl.: G11C 7/16, G06F 12/02

(54) **MULTI-FORMAT PERSONAL DIGITAL AUDIO PLAYER**
PERSÖNLICHER DIGITALER MULTI-FORMAT AUDIOSPIELER
DISPOSITIF NUMERIQUE PERSONNEL DE REPRODUCTION AUDIO EN FORMATS MULTIPLES

(30) Priority: 30.04.1999 US 131888 P
(43) Date of publication of application: 06.02.2002
(73) Proprietor: Thomson Licensing S.A., 92648 Boulogne Cedex (FR)
(72) Inventor: CHEAH, Sin, Hui, Carmel, IN 46032-7040 (US); CSICSATKA, Tibor, Fishers, IN 46038-1616 (US); DICK, Robert, James, Sr., Carmel, IN 46032 (US)
(74) Representative: Hartnack, Wolfgang, Dipl.-Ing.
(86) International application number: PCT/US2000/011610
(87) International publication number: WO 2000/067261

(56) References cited:
- EP-A- 0 570 147
- EP-A- 0 576 409
- WO-A-97/33220
- KRIDNER ET AL: 'A DSP Powered Solid State Audio System' IEEE INTERNATIONAL CONFERENCE ON ACOUSTICS, SPEECH, AND S IGNAL PROCESSING 15 March 1999, PHOENIX, pages 2283 - 2286

## Description

The present invention relates to an apparatus and a method for processing digitally encoded data, and in particular, to a portable apparatus and a method for processing digitally encoded audio data that has been encoded using a selected one of a plurality of encoding/decoding formats. The present invention is particularly advantageous in handheld applications.

The use of portable audio devices capable of playing digitally encoded data is becoming commonplace. In particular, relatively small handheld devices that can process digitally encoded audio data stored on solid state memory devices are becoming popular. Such portable audio devices include those adapted to play digital data that has been encoded, or compressed, and stored on memory chips included within the audio player or on relatively small removable storage media, such as a compactflash™ memory card. The solid state memory based devices are particularly advantageous for use while exercising, or other physical activity, because such devices are not susceptible to skips and other similar problems associated with moving data storage media, such as CDs.

In a solid state memory based device, the digital audio data is loaded onto the memory device by, for example, downloading the data from the internet or from another digital audio player. The data is usually compressed and loaded onto the memory device through a personal computer having appropriate software loaded thereon. The memory device may also include preloaded audio data.

The data is compressed prior to loading onto the memory device and decompressed during playback according to a selected encoding format. A variety of encoding formats for compressing and decompressing audio data is available. As used hereinafter, the term encoding format refers to any encoding/decoding scheme that specifies the syntax and semantics of a compressed bitstream and how the bitstream must be decompressed for reproduction. Such encoding formats include, but are not limited to, MP3 and Real Networks G2. Additionally, new encoding formats are being developed and expected to be available in the future.

However, a disadvantage of current portable audio devices that playback digitally encoded audio data is that a user cannot adjust the operation of the portable audio devices to accommodate a variety of encoding formats. Current portable audio devices, particularly handheld devices, are generally designed and manufactured to work with a pre-selected encoding format. As such, the user cannot choose a different encoding format as the need arises. Such a limitation is problematic because it is desirable to be able to playback a variety of audio data files, wherein different audio data files may have been encoded using different encoding formats. For example, a person's collection may include various audio data files that have been encoded using different encoding formats, certain recordings may only be available in certain encoding formats, and newer encoding formats may make a current encoding format undesirable or obsolete.

Kridner et al: "A DSP Powered Solid State Audio System", 1999 IEEE International Conference on Acoustics, Speech, and Signal Processing, Phoenix, 15. March 1999, pages 2283 to 2286, discloses a DSP powered solid state audio system including a flash card interface for connecting the system to a solid-state memory having audio files stored therein. The DSP may be programmed to decode the audio files transferred from the memory and provide an analog output. The DSP can receive a system software upgrade to utilize future algorithms.

Therefore, it is desirable to provide a portable playback apparatus and a method for playing back data files, in particular audio data files, encoded using one of a plurality of encoding formats. It is particularly desirable to provide a handheld playback apparatus for playing back audio data files encoded using one of a plurality of encoding formats.

It is also desirable to provide a portable playback apparatus and a method for playing back data files, in particular audio data files, encoded using a pre-existing encoding format or an encoding format that may be introduced in the future, without adding additional processing elements. That is, a portable playback apparatus and a method that is both forward and backward compatible with existing and future data encoding formats.

The present invention overcomes the above-noted limitation of current portable audio players, particularly handheld audio players, by providing a portable audio playback device that allows a user to playback audio data files using appropriate ones of a plurality of encoding formats, including new formats that become available in the future.

According to the present invention, decoder files are loaded directly onto the memory device along with the audio data file. The decoder files comprise programs for causing a digital signal processor to process a selected audio data file according to a particular encoding format. When a user selects a particular audio data file, the portable audio player according to the present invention transfers both the selected audio data file and its associated decoder file to a digital signal processor, and thereafter, the digital signal processor decodes the selected audio data file in accordance with the associated decoder file. In this manner, the present portable audio player can be adapted to playback a variety of audio data files using appropriate ones of a plurality of encoding formats.

In one respect, the present invention is a portable audio playback system, comprising: user input means for receiving user commands; data input means for receiving digital data; a data storage device adapted to be removably coupled to the data input means; a digital signal processor; and a micro-controller, coupled to the user input means, the data input means, and the signal processor, for identifying a selected audio data file and an associated decoder file stared on the data storage device in response to a user input, the micro-controller transferring the selected audio data file and the associated decoder file to the digital signal processor, the digital signal processor decoding the selected audio data file in accordance with the associated decoder file.

In another respect, the present invention is, in a portable audio playback device, a method for playing back an audio data file, the audio data file being encoded in accordance with a selected one of a plurality of encoding formats, the method comprising the steps of: identifying a selected audio data file in response to a user input; identifying a decoder file associated with the selected audio data file; transferring the selected audio data file and the associated decoder file to a digital signal processor; decoding the selected audio data file in accordance with the decoder file in the digital signal processor; and providing the decoded audio data file to an output device.

In another respect, the present invention is a method for storing audio data onto a compact data storage device, the compact memory device adapted to be removably coupled to a handheld audio playback device, the method comprising the steps of: encoding audio data in accordance with a selected encoding format to generate an encoded audio data file; storing, in the compact memory device, the encoded audio data file; storing, in the compact memory device, a decoder file for decoding the encoded audio data file in accordance with the selected encoding format; and storing, in the compact memory device, an identifier file that indicates the correspondence between the encoded audio data file and the decoder file.

The present invention is described in more detail with reference to the figures, wherein:
Fig. 1 is a block diagram of a portable audio device according to the present invention;
Figs. 2A-B illustrate a handheld audio apparatus according to the present invention;
Figs. 3-4 are flowcharts illustrating the steps for playing back an audio track using a portable audio device according to the present invention; and
Fig. 5 is a memory map diagram illustrating the various data blocks that are loaded into and processed within the DSP.

### Detailed Description of an Exemplary Embodiment

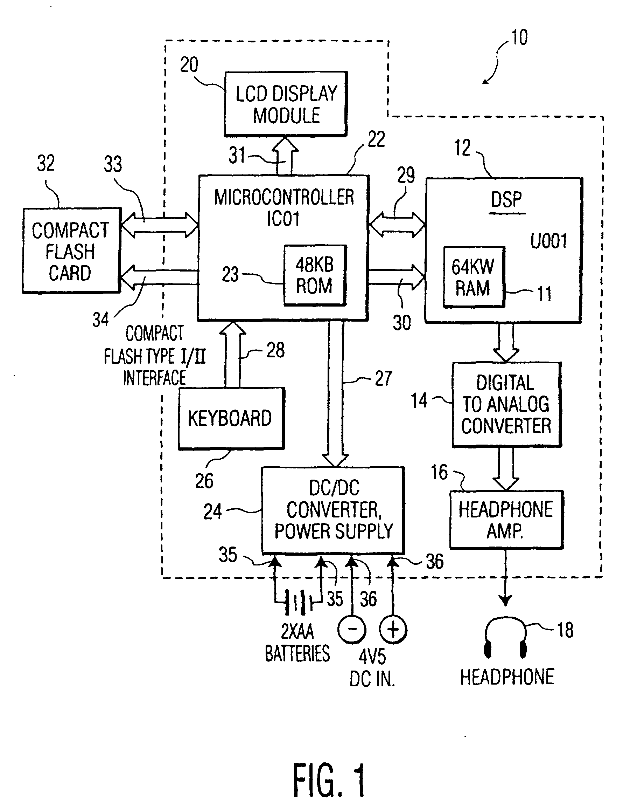

Fig. 1 shows a block diagram of portable audio device 10 according to the present invention. The arrangement and operation of the various elements are described hereinbelow. However, the details of the various elements of audio device 10 are well known to those skilled in the art and will not be discussed here. Audio device 10 comprises micro-controller 22 that controls the various elements and the overall operation of audio device 10, including the transferring data from memory card 32 to DSP 12. Micro-controller 22 includes a suitable amount of memory 23, in this case 48 KB of ROM, which includes various instruction sets, decryption programs, key files and a security code for controlling the operation of audio player 10 stored thereon. Suitable microcontrollers include, but are not limited to, µPC78A4036 manufactured by NEC Corporation.

Audio device 10 also includes digital signal processor ("DSP") 12 that may be programmed to perform a variety of signal processing functions during playback of a selected audio data file. In this case, the functions that DSP 12 performs during playback includes, but is not limited to, decrypting a decryption program using a security code, decrypting a decoder file with the decryption program using a first key, decrypting an audio data file with the decryption program using a second key and a unique identifier associated with memory card 32, and decoding the audio data file using the decoder file. Other functions include volume control, digital sound equalizer, and sample conversion. In that regard, DSP 12 includes on-board memory 11, in this case 64 KW of RAM, wherein the decryption program, key files, security code, decoder files and audio data files, and various other required data are loaded during playback.

The decoder files comprise programs that control the decoding operations of DSP 12 and the audio data files include data associated with the audio content. Both the audio data files and the decoder files are stored in memory card 32 in encrypted form. The decoder file is transferred to DSP RAM 11 from memory card 32 and decrypted as described further below. Suitable DSP units, include, but are not limited to, TMS320NC5410 manufactured by Texas Instruments, Inc. of Dallas, Texas.

As a selected audio data file is decoded, DSP 12 provides the decoded data stream to digital to analog converter 14. D/A converter 14 converts the digital output of DSP 12 into an analog signal and provides the analog signal to headphone amplifier 16. The analog signals are amplified by headphone amplifier 16 and provided to headphone 18 via output jacks disposed on the housing of audio player 10.

In the preferred embodiment, audio player 10 is adapted to operate with memory card 32. Memory card 32 is a solid state data storage device that can be used to store various data files, including encoded audio data files and decoder files for controlling the decoding operation of DSP 12. Memory card 32 may be removably coupled to audio player 10 via memory card port 38 and a large amount of data can be readily transferred from memory card 32 to audio player 10 through data bus 33. The solid state nature of memory card 32 allows large amount of data to be transferred to audio player 10 without skips and other similar disadvantages associated with media, such as CDs, that require precise moving parts. Suitable memory cards include, but are not limited to, CompactFlash™ type I and II of the CompactFlash Association (CFA) standard (IDE Mode). Also, hard drive type media, such as Microdrive™ manufactured by IBM Corporation of Armonk, New York, may be used.

Using the present invention, several decoder files and relatively large amounts of audio data can be stored on currently available flash memory cards. For example, a 64 MB compactflash™ card provides approximately 68 minutes of audio at MP3 bit-rate of 128 Kbps, wherein approximately 60-70KB are required for the decoder programs and approximately 1 MB is required for each minute of music output.

Audio data files and associated decoder files are loaded onto memory card 32 using a PC, or other similar device, having music management software loaded thereon. The music management software is designed to load the desired audio data files along with the associated decoder files onto memory card 32. The music management software is implemented using programming methods known in the art. Alternatively, the required data may be downloaded through another source, for example, through the Internet or another player, wherein the downloaded data includes the desired audio data files and their associated decoder files.

Keyboard 26 comprises a plurality of keys disposed on the housing of audio player 10 for allowing a user to select a particular audio data file for playback and to control playback settings. LCD display module 20 is coupled to micro-controller 22 and provides a listing of the selections available on memory card 32 and also status information regarding audio player 10.

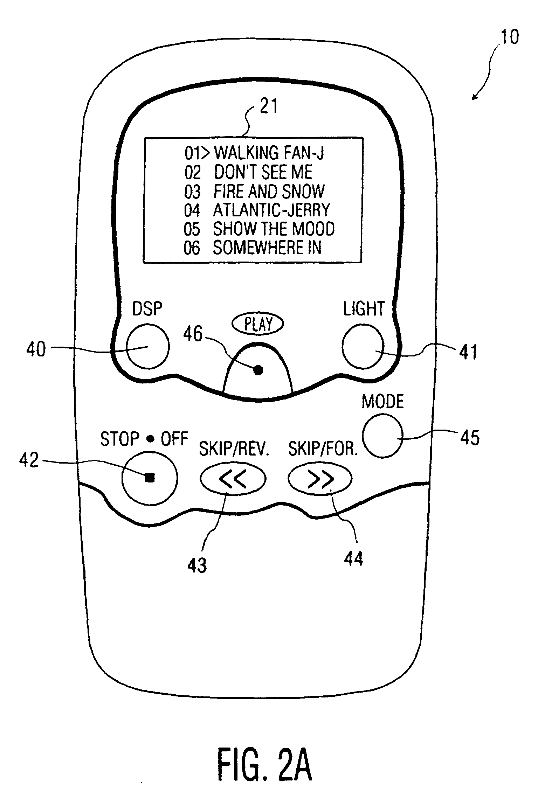

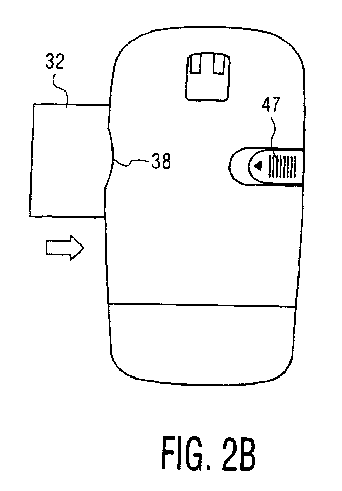

Figs. 2A-B illustrate the displays and buttons disposed on the housing of audio player 10. As shown in Fig. 2A, audio player 10 includes display 21 that displays the audio data files stored on memory card 32 and various status information associated with audio player 10. PLAY button 46 allows a user to begin play of a selected data file. STOP/OFF button 42 allows a user to stop play and turn audio player 10 OFF. SKIP/FOR. button 44 and SKIP/REV. button 43 allow a user to scroll between different audio data files displayed on display 21. Mode button 45 allows a user to a particular playback mode, including NORMAL, REPEAT PLAYBACK and SHUFFLE. DSP button 40 allows a user to select one of a plurality of DSP modes, including FLAT, BASS, BOOST, ROCK, POP, JAZZ, and EQ. Fig. 2B shows memory card port 38 having memory card 32 inserted therein, and ejector lever 47 for ejecting memory card 32 from memory card port 38.

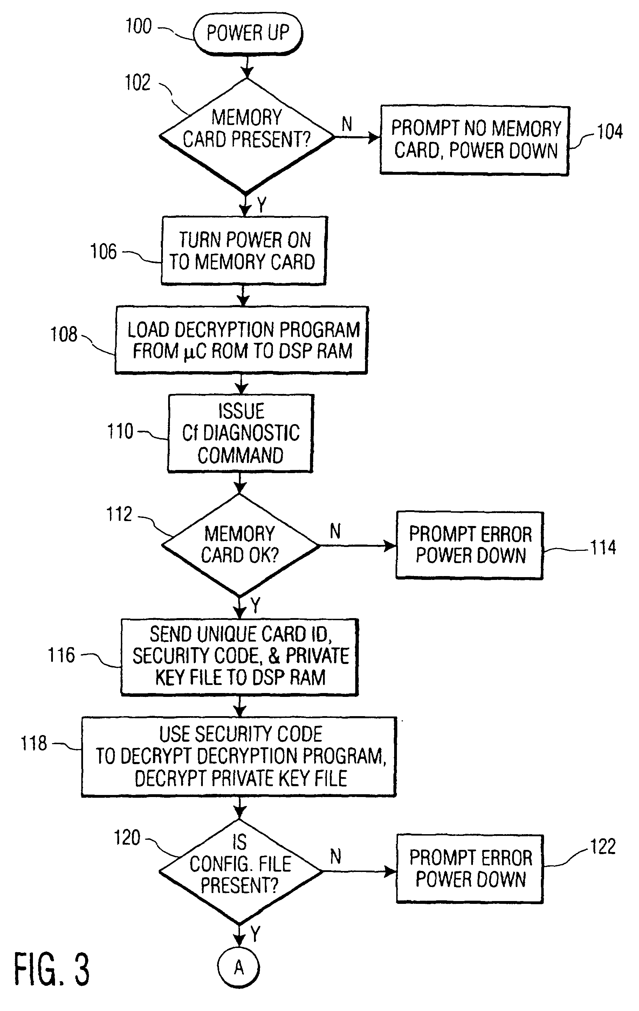

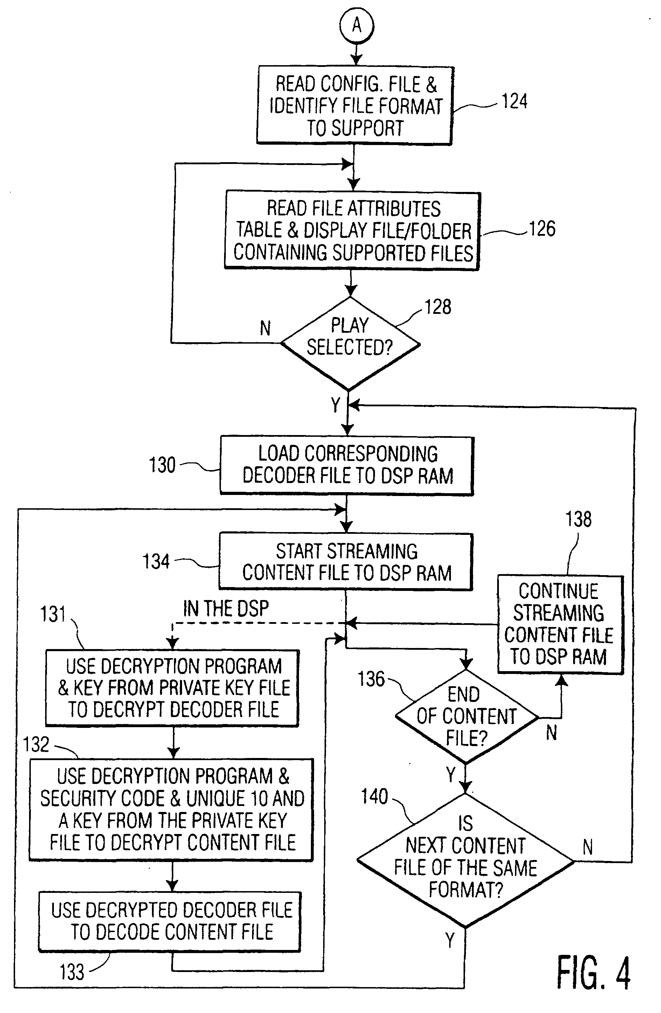

After insertion of memory card 32 into memory card port 38 of audio player 10 and prior to beginning playback, micro-controller 22 reads memory card 32, in particular a configuration file stored therein, to identify and display the audio data files stored on memory card 32, and their associated encoding formats. When the user selects a particular audio data file for playback, micro-controller 22 loads the selected audio data file and the appropriate decoder file into DSP RAM 11, wherein DSP 12 decrypts both the data and decoder files, and then decodes the selected audio data file using the decoder file. Thus, the decoder files on memory card 32 allow audio player 10 to be adapted to process the various encoding formats associated with the audio data files stored on memory card 32. In effect, portable audio player 10 is software upgraded, as necessary, by the decoder files stored on memory card 32 when the user selects a particular audio data file stored on memory card 32. The steps associated with processing a selected audio data file from memory card 32 using audio player 10 is shown in the flowcharts of Figs. 3 and 4, and described below.

Figs. 3 and 4 show flowcharts illustrating the steps for processing a selected audio data file in accordance with the present invention. After powering UP in step 100, micro-controller 22 of audio player 10 checks for the presence of memory card 32 in flash card port 38 in step 102. If memory card 32 is not detected in flash card port 38, audio player 10 powers DOWN in step 104. If memory card 32 is detected, audio player 10 turns ON the power to memory card 32 in step 106.

In step 108, micro-controller 22 transfers the decryption program stored in micro-controller ROM 23 to DSP RAM 11. In step 110, micro-controller 22 issues a diagnostic check command to cause memory card 32 to perform a set of self-diagnostic checks. If memory card 32 is determined to be in a faulty condition in step 112, micro-controller 22 indicates that an error condition exists and powers DOWN memory card 32 in step 114.

If memory card 32 is determined to be in an acceptable condition, micro-controller 22 reads the unique ID number embedded in memory card 32. In step 116, micro-controller 22 transfers the unique ID number of memory card 32, and a private key file and a security code stored in micro-controller ROM 23 to DSP RAM 11. Following this transfer, in step 118, DSP 12 decrypts the decryption program using the security code. The decryption program specifies certain keys using a pointer that specifies the memory location of DSP RAM 11 wherein the desired keys are stored, from the key file to be used during subsequent decryption operations as noted below.

In step 120, micro-controller 22 determines whether a configuration file is present in memory card 32. In step 122, if a configuration file is not found, micro-controller 22 causes an error indication to be displayed on display 21 and powers DOWN memory card 32. In step 124, if a configuration file is present, micro-controller 22 reads the configuration file and identifies the various file formats that need to be supported for the data files stored on memory card 32. The configuration file also includes information that equates the file extension of the audio data files with particular decoder files stored in memory card 32. In step 126, micro-controller 22 reads the file attribute table stored on memory card 32 and causes display 21 to display the file/folders stored in memory card 32. At this point, the user may select a desired one of the displayed audio data files, or music tracks, for playback.

When an audio data file is selected for playback in step 128, micro-controller 22 and DSP 11 perform a number of steps, including several concurrent steps to provide audio playback. First, micro-controller 22 identifies and transfers the corresponding decoder file from memory card 32 to DSP RAM 11 in step 130. For example, if the user selects an MP3 file, micro-controller 22 transfers the MP3 decoder file from memory card 32 to DSP RAM 11. At this point, the MP3 decoder file is encrypted and must be decrypted before it can be used to control the decoding operation of DSP 12. In step 131, DSP 12 decrypts the decoder file loaded in DSP RAM 11 using the decryption program that was decrypted in step 118 and a first key in the key file specified by the decryption program.

In step 134, micro-controller 22 begins streaming the selected audio data file from memory card 32 to DSP 12. In step 132, DSP 12 uses the decryption program to decrypt the streaming audio data file. An additional security layer with regard to the decryption of the audio data file is provided as follows. A second key from the private key file that is specified by the decryption program and the unique ID number of memory card 32 are used to generate a final key, wherein the final key is used by the decryption program to decrypt the audio data file.

The music management software is designed to use the unique ID number of memory card 32 to encrypt the audio data file when the audio data file is stored in memory card 32. As such, the use of the unique ID number of memory card 32 to generate the final key prevents audio player 10 from playing an audio data file that was copied from another memory card. In step 133, DSP 12 uses the decrypted decoder file to decode the decrypted audio data file in accordance with the appropriate encoding format. The decoded audio data is provided to D/A converter 14 and headphone amp 16 for reproduction.

In step 136, it is determined whether all of the data in the selected audio data file has been transferred to DSP RAM 11. If not, micro-controller 22 continues to stream data from memory card 32 to DSP RAM 11. If the transfer of data is complete as determined in step 136, micro-controller 22 determines in step 140 whether the next audio data file is encoded using the same format as the previous audio data file. If the encoding format of the next audio data file is the same as the previous encoding format, micro-controller 22 returns to step 134 and starts streaming the data from the next audio data file, which data is subsequently decrypted and decoded in steps 132 and 133 as before.

If the encoding format of the next audio data file differs from the encoding format of the previous audio data file, micro-controller 22 returns to step 130. In this case, a new decoder file associated with the next audio data file is transferred to DSP RAM 11, and the steps of decrypting the decoder file, streaming the audio data file, decrypting the data file, and decoding the data file using the newly loaded decoder file is repeated. In this manner, audio player 10 is able to playback audio data files encoded using any one of a plurality of encoding formats, as long as the decoder file associated with the selected encoding format is available and can be downloaded onto DSP RAM 11. In the present embodiment, the necessary decoder files are stored in memory card 32 along with the audio data files. As such, audio player 10 can be updated to play different encoding formats by software updating of the DSP via decoder files stored along with the audio data files in memory card 32. Thus, audio player 10 is capable of playing back data files encoded using a variety of encoding formats, including encoding formats that become available in the future.

In the present invention, audio data files are loaded onto memory card 32 using music management software that encodes the audio data files in accordance with a selected encoding format, such as MP3, encrypts the encoded data files, and then stores the encrypted, encoded data files. Various encryption and decryption methods known to those skilled in the art for generating an encrypted file using a selected key, and then decrypting the encrypted file using the selected key may be used. In the present invention, the decoder files are encrypted using a first key, and the audio data files are encrypted using another key that is generated using the unique identifier on memory card 32. The music management software stores the encrypted audio data files and appropriate encrypted decoder files onto memory card 32. The music management software also generates, and modifies as necessary, a configuration file and a file attribute table to provide information regarding the various data files and decoder files stored on memory card 32. Using the configuration file and the file attributes table, audio player 10 is able to determine the correct encoding format for each content file, display the available file on display 21 and download appropriate decoder file for each content file in response to a user selection.

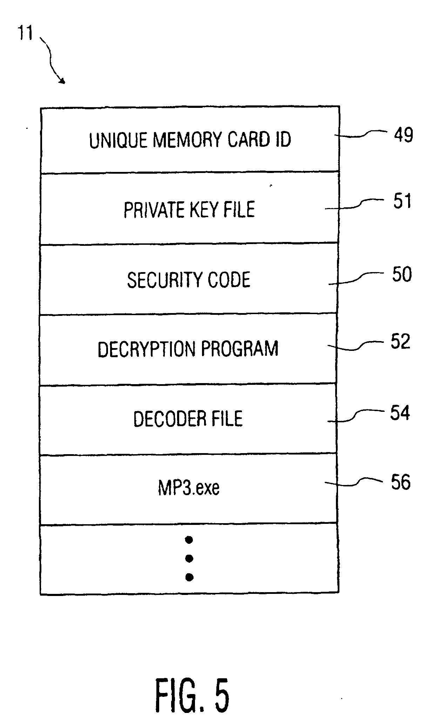

Fig. 5 is a memory map associated with DSP RAM 11 illustrating the various data files that are transferred to DSP RAM 11 and interactions therebetween. initially, the unique ID number associated with memory card 32 is stored in memory portion 49. The security code and private key files that are stored in micro-controller ROM 23 are transferred to DSP RAM 11 and stored in respective memory portions 50 and 51. Also, the decryption program is read into memory portion 52 from micro-controller ROM 23. The decoder file associated with a selected audio data file is stored in memory portion 54, and the audio data files are stored in memory portion 56. It is to be understood that the transfer of the various data blocks and the actual arrangement of the data blocks in DSP RAM may be programmed as desired using any one of programming techniques known to those skilled in the art.

As described above, the security code in block 50 is used to decrypt the decryption program in block 52. The decryption program is used to decrypt the decoder file in block 54 and the audio data file in block 56. The decryption program includes a pointer that is used to specify a first key to be used during decryption of the decoder file. Also, a second key specified by the decryption program and the unique ID number of memory card 32 in block 49 are used to generate a final key, and the final key is used by the decryption program to decrypt the selected audio data file. The decoder file is then used to decode the decrypted audio data file. It can be seen that different keys may be selected in the private key file by changing the pointers to the memory locations where the private key file is stored or by changing the locations where the private key file is stored.

It will be apparent to those skilled in the art that although the present invention has been described in terms of an exemplary embodiment, modifications and changes may be made to the disclosed embodiment without departing from the essence of the invention. For example, although the present invention has been described with reference to a memory card that is adapted to be removably coupled to audio player 10, the present invention may be implemented using a memory chip that is fixedly disposed within audio player 10, wherein the decoder program and audio data files are loaded onto the fixed memory chip by the music management software. Also, it is herein recognized that the present feature of loading the appropriate decoder programs and the audio data files may be implemented in the music management software using any one of a number of conventionally known programming methods, or combination of programming methods. Also, although the above is described in reference to an audio data player, the present invention may be extended to any portable data processing device, for example, video display devices, wherein the data may be encoded using one of a plurality of data encoding formats. Also, the audio data files and decoder files may be stored and read from magnetic or optical media. Therefore, it is to be understood that the present invention is defined in the appended claims.

## Claims

1. Method for playing back an audio data file in a handheld audio playback device (10), the audio data file being encoded in accordance with a selected one of a plurality of encoding formats, the method including the steps of:
- identifying (124) a selected audio data file stored on a removable data storage device (32) in response to a user input;
- decoding (133) the selected audio data file in accordance with a decoder file in a digital signal processor (12);
- providing the decoded audio data file to an output device (14, 16),
**characterised by** the steps:
- reading (124, 126) a configuration file stored on the removable data storage device (32) to identify a decoder file stored on the removable data storage device (32) and associated with the selected audio data file, the decoder file comprising a program to control the operations of the digital signal processor (12), whereby the selected audio data file, the configuration file and the decoder file are all being stored on the same removable data storage device (32);
- transferring (130) the selected audio data file and the associated decoder file to the digital signal processor from the removable data storage device that is coupled to the handheld audio playback device for playback;
- repeating (126-140) the identifying and reading steps for each selected audio data file, and transferring the decoder file as required to perform the decoding, and repeating the decoding and providing steps for each selected audio data file in accordance with the associated decoder file.

2. Method according to claim 1, further comprising the steps of reading (116) a unique identification associated with the removable data storage device (32), and decrypting (131, 132) the audio data file and the associated decoder file using the unique identification.

3. Method for storing an audio data file on a removable data storage device (32), comprising the steps of:
- identifying an audio data file to be transferred to the removable data storage device in response to a user input;
- identifying a compression format associated with the identified audio data file, and a decoder file associated with the identified compression format;
- transferring the identified audio data file to the removable data storage device;
- transferring the associated decoder file to the removable data storage device;
- identifying a configuration file stored on the removable data storage device for associating audio files and decoder files stored on the removable data storage device (32);
- updating the configuration file upon transfer of the identified audio data file and associated decoder file.

4. Method according to one of claims 1 to 3, wherein the removable data storage device is a solid state data storage device (32).

5. Handheld audio playback apparatus (10) for playing back an audio data file encoded in accordance with a selected one of a plurality of encoding formats, the apparatus including:
- means (38) for accepting a user removable data storage device (32);
- user input means (26) for receiving user commands;
- data input means (33, 34) for receiving digital data;
- a digital signal processor (12);
- output means (12, 16) for receiving decoded data and providing an analog audio output;
- a micro-controller (22), coupled to the user input means, the data input means, the output means and the digital signal processor,
**characterised in that** the micro-controller identifies a user-selected audio data file (56) and reads configuration information that correlates the user selected audio data file with a decoder file (54) associated with the user-selected audio data file, the decoder file comprising a program for controlling the operation of the digital signal processor, whereby the user-selected audio data file and the configuration information and the decoder file are all being stored on a single removable data storage device (32),
and **in that** the micro-controller (22) transfers the user selected audio data file and the associated decoder file from the single user removable data storage device to the digital signal processor (12) in response to a user selection, the digital signal processor decoding the user-selected audio data file in accordance with the associated decoder file, wherein the decoding is performed entirely within the digital signal processor and wherein the micro-controller performs the steps of identifying the user selected audio data file and the associated decoder file, and transferring the selected audio data file and the associated decoder file, as required, for each user-selected audio data file.

6. Apparatus according to claim 5, wherein the removable data storage device comprises a solid state data storage device (32) coupled to the micro-controller.

7. Apparatus according to claim 5 or 6, wherein the removable data storage device (32) includes a unique identification stored thereon, the micro-controller (22) transferring the unique identification to the playback apparatus and decrypting the audio data file and the associated decoder file.

## Patentansprüche

1. Verfahren zur Wiedergabe einer Audiodaten-Datei in einer handgehaltenen Audio-Wiedergabevorrichtung (10), wobei die Audiodaten-Datei gemäß einem aus einer Mehrzahl von Kodierformaten ausgewählten Kodierformat kodiert ist, und wobei das Verfahren die Schritte enthält:
- Identifizieren (124) einer ausgewählten Audiodaten-Datei, die auf einer abnehmbaren Datenspeichervorrichtung (32) gespeichert ist, als Reaktion auf eine Benutzer-Eingabe;
- Dekodieren (133) der ausgewählten Audiodaten-Datei gemäß einer Dekodierer-Datei in einem digitalen Signalprozessor (12);
- Liefern der dekodierten Audiodaten-Datei an eine Ausgangsvorrichtung (14, 16), **gekennzeichnet durch** die Schritte:
- Lesen (124, 126) einer Konfigurations-Datei, die in der abnehmbaren Datenspeichervorrichtung (32) gespeichert ist, um eine Dekodierer-Datei zu identifizieren, die in der abnehmbaren Speichervorrichtung (32) gespeicher und der ausgewählten Audiodaten-Datei zugeordnet ist, wobei die Dekodierer-Datei ein Programm umfasst, um die Operationen des digitalen Signalprozessors (12) zu steuern, wobei die ausgewählte Audiodaten-Datei, die Konfigurations-Datei und die Dekodierer-Datei alle in derselben abnehmbaren Datenspeichervorrichtung (32) gespeichert sind;
- Weiterleiten (130) der ausgewählten Audiodaten-Datei und der 'zugeordneten Dekodierer-Datei aus der abnehmbaren Datenspeichervorrichtung, die mit der handgehaltenen Audio-Wiedergabevorrichtung für die Wiedergabe verbunden ist, zu dem digitalen Signalprozessor;
- Wiederholen (126 - 140) der Identifizierungs- und Leseschritte für jede ausgewählte Audiodaten-Datei, und Weiterleiten der Dekodierer-Datei wie erforderlich, um die Dekodierung auszuführen, und Wiederholen des Dekodierungs- und Lieferschrittes für jede ausgewählte Audiodaten-Datei gemäß der zugeordneten Dekodierer-Datei.

2. Verfahren nach Anspruch 1, das ferner die Schritte umfasst: Lesen (116) einer eindeutigen Identifizierung, die der abnehmbaren Datenspeichervorrichtung (32) zugeordnet ist, und Entschlüsseln (131, 132) der Audiodaten-Datei und der zugeordneten Dekodierer-Datei unter Verwendung der eindeutigen Identifizierung.

3. Verfahren zur Speicherung einer Audiodaten-Datei auf einer abnehmbaren Datenspeichervorrichtung (32), umfassend die Schritte:
- Identifizieren einer Audiodaten-Datei, die als Reaktion auf eine Benutzer-Eingabe zu der abnehmbaren Datenspeichervorrichtung weitergeleitet werden soll;
- Identifizieren eines Kompressionsformats, das der identifizierten Audiodaten-Datei zugeordnet ist, und einer Dekodierer-Datei, die dem identifizierten Kompressionsformat zugeordnet ist;
- Weiterleiten der identifizierten Audiodaten-Datei zu der abnehmbaren Datenspeichervorrichtung;
- Weiterleiten der zugeordneten Dekodierer-Datei zu der abnehmbaren Datenspeichervorrichtung;
- Identifizieren einer Konfigurationsdatei, die in der abnehmbaren Datenspeichervorrichtung gespeichert ist, um Audiodateien und Dekodierer-Dateien, die in der abnehmbaren Datenspeichervorrichtung (32) gespeichert sind, zuzuordnen;
- Aktualisieren der Konfigurations-Datei bei der Weiterleitung der identifizierten Audiodaten-Datei und der zugeordneten Dekodierer-Datei.

4. Verfahren nach Anspruch 1 bis 3, bei dem die abnehmbare Datenspeichervorrichtung eine Festkörper-Datenspeichervorrichtung (32) ist.

5. Handgehaltene Audio-Wiedergabevorrichtung (10) zur Wiedergabe einer Audiodaten-Datei, die gemäß einem aus einer ausgewählten Mehrzahl von Kodierformaten kodiert ist, wobei die Vorrichtung umfasst:
- Mittel (38) zum Akzeptieren einer von einem Benutzer abnehmbaren Datenspeichervorrichtung (32);
- Benutzer-Eingabemittel (26) zum Empfang vom Benutzerbefehlen;
- Dateneingangsmittel (33, 34) zum Empfang von digitalen Daten;
- einen digitalen Signalprozessor (12);
- Ausgangsmittel (12, 16) zum Empfang von dekodierten Daten und zum Liefern eines analogen Audio-Ausgangs;
- einen Microcontroller (22), der mit den Benutzer-Ausgangsmitteln, den Daten-Eingangsmitteln, den Ausgangsmitteln und dem digitalen Signalprozessor verbunden ist; **dadurch gekennzeichnet dass**, der Micro-controller eine vom Benutzer ausgewählte Audiodaten-Datei (56) identifiziert und Konfigurations-Informationen liest, die die vom Benutzer ausgewählte Audiodaten-Datei mit einer Dekodierer-Datei (54) korreliert, die der vom Benutzer ausgewählten Audiodaten-Datei zugeordnet ist, wobei die Dekodierer-Datei ein Programm zur Steuerung der Operation des digitalen Signalprozessors umfasst, wobei die vom Benutzer ausgewählte Audiodaten-Datei, und die Konfigurations-Informationen und die Dekodierer-Datei alle in einer einzigen abnehmbaren Datenspeichervorrichtung (32) gespeichert sind, und dass der Microcontroller (22) die vom Benutzer ausgewählte Audiodaten-Datei und die zugeordnete Dekodierer-Datei von der einzelnen vom Benutzer abnehmbaren Datenspeichervorrichtung zu dem digitalen Signalprozessor (12) als Reaktion auf eine Benutzer-Auswahl weiterleitet und der digitale Signalprozessor die vom Benutzer ausgewählte Audiodaten-Datei gemäß der zugeordneten Dekodierer-Datei dekodiert, wobei die Dekodierung vollständig innerhalb des digitalen Signalprozessors ausgeführt wird, und wobei der Microcontroller die Schritte der Identifizierung der vom Benutzer ausgewählten Audiodaten-Datei und der zugeordneten Dekodierer-Datei ausführt, und wobei die ausgewählte Audiodaten-Datei und die zugehörige Dekodierer-Datei wie erforderlich zu jeder vom Benutzer ausgewählten Audiodaten-Datei weitergeleitet wird.

6. Vorrichtung nach Anspruch 5, bei der die abnehmbare Datenspeichervorrichtung eine Festkörper-Datenspeichervorrichtung (32) ist, die mit dem Micro-controller verbunden ist.

7. Vorrichtung nach Anspruch 5 oder 6, bei der die abnehmbare Datenspeichervorrichtung (32) eine in ihr gespeicherte eindeutige Identifizierung enthält, wobei der Micro-controller (22) die eindeutige Identifizierung zu der Wiedergabevorrichtung weiterleitet und die Audiodaten-Datei und die zugeordnete Dekodierer-Datei entschlüsselt.

## Revendications

1. Procédé de lecture d'un fichier de données audio dans un dispositif de lecture audio de poche (10), le fichier de données audio étant codé conformément à un format sélectionné parmi une pluralité de formats de codage, le procédé comprenant les étapes suivantes :
- identification (124) d'un fichier de données audio sélectionné enregistré dans un dispositif amovible de mémorisation de données (32) en réponse à une entrée effectuée par un utilisateur ;
- décodage (133) du fichier de données audio sélectionné conformément à un fichier décodeur présent dans un processeur numérique de signaux (12) ;
- fourniture du fichier de données audio décodé à un dispositif de sortie (14, 16),
**caractérisé par** les étapes suivantes :
- lecture (124, 126) d'un fichier de configuration enregistré dans le dispositif amovible de mémorisation de données (32) pour identifier un fichier décodeur enregistré dans le dispositif amovible de mémorisation de données (32) et associé au fichier de données audio sélectionné, le fichier décodeur comportant un programme de commande des opérations du processeur numérique de signaux (12), le fichier de données audio sélectionné, le fichier de configuration et le fichier décodeur étant tous enregistrés dans le même dispositif amovible de mémorisation de données (12) ;
- transfert (130) en vue de sa lecture du fichier de données audio sélectionné et du fichier décodeur associé au processeur numérique de signaux depuis le dispositif amovible de mémorisation de données qui est connecté au dispositif de lecture de poche ;
- répétition (126 à 140) des étapes d'identification et de lecture pour chaque fichier de données audio sélectionné et transfert du fichier décodeur nécessaire au décodage et répétition des étapes de décodage et de fourniture pour chaque fichier de données audio sélectionné conformément au fichier décodeur associé.

2. Procédé selon la revendication 1, comportant en outre les étapes de lecture (116) d'une identification unique associée au dispositif amovible de mémorisation de données (32) et décryptage (131, 132) du fichier de données audio et du fichier décodeur associé en utilisant l'identification unique.

3. Procédé de mémorisation dans un dispositif amovible de mémorisation de données (32), comportant les étapes suivantes :
- identification d'un fichier de données audio à transférer au dispositif amovible de mémorisation de données en réponse à une entrée effectuée par un utilisateur ;
- identification d'un format de compression associé au fichier de données audio identifié et d'un fichier décodeur associé au format de compression identifié ;
- transfert du fichier de données audio identifié au dispositif amovible de mémorisation de données ;
- transfert du fichier décodeur associé au dispositif amovible de mémorisation de données ;
- identification d'un fichier de configuration enregistré dans le dispositif amovible de mémorisation de données pour associer les fichier audio et les fichiers décodeurs enregistrés dans le dispositif amovible de mémorisation de données (32) ;
- mise à jour du fichier de configuration lors du transfert du fichier de données audio identifié et du fichier décodeur associé.

4. Procédé selon l'une des revendications 1 à 3, dans lequel le dispositif amovible de mémorisation de données est un dispositif de mémorisation de données à semiconducteurs (32).

5. Appareil de lecture audio de poche (10) pour lire un fichier de données audio codé selon un format sélectionné parmi une pluralité de formats de codage, l'appareil comprenant :
- un moyen (38) de réception d'un dispositif amovible par un utilisateur de mémorisation de données (32) ;
- un moyen d'entrée d'utilisateur (26) destiné à recevoir des commandes entrées par un utilisateur ;
- un moyen d'entrée de données (33,34) destiné à recevoir des données numériques ;
- un processeur numérique de signaux (12) ;
- un moyen de sortie (12, 16) destiné à recevoir des données décodées et les générer en sortie sous forme audio analogique ;
- un microcontrôleur (22) connecté au moyen d'entrée d'utilisateur, au moyen d'entrée de données, au moyen de sortie et au processeur numérique de signaux,
**caractérisé en ce que** le microcontrôleur identifie un fichier de données audio sélectionné par un utilisateur (56) et lit les informations de configuration qui mettent le fichier de données audio sélectionné par un utilisateur en corrélation avec un fichier décodeur (54) associé au fichier de données audio sélectionné par un utilisateur, le fichier décodeur comportant un programme de commande du fonctionnement du processeur numérique de signaux, le fichier de données audio sélectionné par un utilisateur, les informations de configuration et el fichier décodeur étant tous enregistrés dans un dispositif amovible de mémorisation de données unique (32).
et **en ce que** le microcontrôleur (22) transfère le fichier de données audio sélectionné par un utilisateur et le fichier décodeur associé d'un dispositif de mémorisation de données amovible par un utilisateur unique au processeur numérique de signaux (12) en réponse à une sélection effectuée par un utilisateur, le processeur numérique de signaux décodant le fichier de données audio sélectionné par un utilisateur conformément au fichier décodeur associé, dans lequel le décodage est effectué entièrement dans le processeur numérique de signaux et dans lequel le microcontrôleur réalise les étapes d'identification du fichier de données audio sélectionné par un utilisateur et du fichier décodeur associé et de transfert du fichier de données audio sélectionné et du fichier décodeur associé, selon les besoins, pour chaque fichier de données audio sélectionné par un utilisateur.

6. Appareil selon la revendication 5, dans lequel le dispositif amovible de mémorisation de données comporte un dispositif de mémorisation de données à semiconducteurs (32) connecté au microcontrôleur.

7. Appareil selon la revendication 5 ou 6, dans lequel le dispositif de mémorisation de données amovible (32) comprend une identification unique qui y est enregistrée, le microcontrôleur (22) transférant l'identification unique à l'appareil de lecture et décryptant le fichier de données audio et le fichier décodeur associé.
